# EUROPEAN PATENT SPECIFICATION

(11) **EP 1 783 159 B1**
(45) Date of publication and mention of the grant of the patent: **29.02.2012**
(21) Application number: 05751284.0
(22) Date of filing: 08.06.2005
(51) Int. Cl.: C08J 5/18, C08K 5/3475, C08K 5/541, C08L 23/08, H01L 31/02

(54) **RESIN FILM**
HARZFOLIE
FILM DE RÉSINE

(30) Priority: 08.06.2004 JP 2004169509
(43) Date of publication of application: 09.05.2007
(73) Proprietor: Bridgestone Corporation, Tokyo 104-0031 (JP)
(72) Inventor: OKADA, Tokuo, Bridgestone Corporation, Yokohama-shi, Kanagawa 244-8510 (JP); AOKI, Ichiro, Bridgestone Corporation, Yokohama-shi, Kanagawa 244-8510 (JP); ISHII, Yorinobu, Bridgestone Corporation, Yokohama-shi, Kanagawa 244-8510 (JP)
(74) Representative: Andrews, Timothy Stephen
(86) International application number: PCT/JP2005/010896
(87) International publication number: WO 2005/121227

(56) References cited:
- JP-A- 4 362 044
- JP-A- 8 072 199
- JP-A- 10 341 030
- JP-A- 57 196 747
- JP-A- 58 060 579
- JP-A- 62 148 509
- JP-A- 2002 187 236
- JP-A- 2002 368 243
- JP-A- 2005 029 588

## Description

### Background of Invention

### 1. Field of the invention

The present invention relates to a resin film useful in a solar cell or solar cell module, a laminated glass having a metal layer and an organic glass.

### 2. Description of the Related Art

A solar cell (solar cell module) has been paid attention as a device directly converting solar energy into electric energy from the viewpoints of effective use of natural resources and ecology, and various solar cells have been developed.

In a solar cell, silicon photovoltaic elements (photovoltaic elements made of silicon etc.) are sealed by ethylene-vinyl acetate copolymer (EVA) films for sealing between a glass plate as a transparent front surface (light receiving face) protection member and a rear surface protection member (backside covering material).

A solar cell is prepared by the following steps: a glass plate, EVA film (sealing film), silicon photovoltaic elements, EVA film (sealing film) and a backside covering material are superposed and cured or crosslinked by heating the EVA films in this order to form a superposed product. Then, EVA is melted and cured or crosslinked by heating to unify the superposed product, whereby a solar cell can be obtained.

It is important that the solar cell has excellent moisture-proof property in order to prevent occurrence of rust on conducting wire or electrodes within the cell owing to permeation of moisture or water. Therefore a glass plate is conventionally used as the front surface protection member to prevent the occurrence of rust (see JP-A-2000-174296).

### Summary of the Invention

The study of the present inventors reveals that an EVA film is apt to generate acetic acid by hydrolysis with time under high temperature owing to permeation of moisture or water because EVA contains vinyl acetate as a constituent (or EVA essentially contains a bit of acetic acid) and hence the generated acetic acid comes in contact with conducting wire or electrodes within the cell to promote occurrence of rust.

Further, the EVA film is used in a laminated glass such as a windshield of automobile. The laminated glass generally has a structure that two glass plates (or a glass plate and a plastic plate) are bonded through a transparent adhesive layer (intermediate layer) comprising an organic resin. Recently a laminated glass for reflecting heat rays, in which a deposited metal film is inserted between a glass plate and an EVA film, has been increasingly used. Also in the metallized film, occurrence of rust is promoted due to acetic acid generated from the EVA film in the same manner as above. The demand of the laminated glass or glass for reflecting heat rays is developing in use applications such as construction materials.

The EVA film used as above is basically required to have high transparency and hence a film capable of preventing the occurrence of rust with maintaining the high transparency is desired.

In view of the above viewpoints, the object of the present invention is to provide a resin film free from acetic acid generated by hydrolysis with time owing to change of environment and having high transparency.

Further, the object of the present invention is to provide a resin film having excellent durability and high transparency useful as a sealing film of a solar cell and a transparent adhesive layer of a laminated glass.

The present invention is provided by a resin film comprising ethylene-vinyl acetate copolymer,
which has an extracted acetic acid amount of not more than 200 ppm (especially not more than 100 ppm), the extracted acetic acid amount being an acetic acid amount obtained by allowing the resin film to stand for 100 hours under the conditions of temperature of 85°C and relative humidity of 85% and thereafter heating water containing the resin film under boiling and reflux to extract acetic acid from the resin film.

The extracted acetic acid amount using water is considered to be correlated with extent of corrosion (rust).

In the resin film, it is preferred that the ethylene-vinyl acetate copolymer has been further crosslinked by a crosslinker, and the ethylene-vinyl acetate copolymer has been further crosslinked by a crosslinking auxiliary agent. Further the resin film preferably contains a silane-coupling agent. Generally, the use of these agents advantageously brings about prevention of occurrence of acetic acid.

The crosslinker is preferably contained in the amount of 0.1 to 2 part by weight, particularly 0.1 to 1 part by weight, based on the weight of the ethylene-vinyl acetate copolymer. The amount is basically depended on the amount (ratio) of a vinyl acetate recurring unit of the ethylene-vinyl acetate copolymer. Generally the use of the crosslinker within the above-mentioned range advantageously enables enhancement of transparency and repression of occurrence of acetic acid.

As described above, the crosslinker is preferably contained in the amount of not more than 1 part by weight. This is because a curing time is reduced when the crosslinker is used in excess amount but bubbles are apt to be generated in an EVA film, which impairs the transparency. The occurrence of the bubbles is considered to be derived from acetic acid. An EVA film having reduced transparency is difficultly used for a covering material of a solar cell. In order to acquire the transparency, the resin film of the invention preferably is a film in which loss in weight after heating the resin film at 160°C for 30 minutes is not more than 2.0 % by weight based on the resin film before the heating. Further it is preferred that a crosslinking auxiliary agent is added to the resin film to promote the cross-linking.

The crosslinking auxiliary agent is preferably contained in the amount of 0.1 to 2 part by weight, particularly 0.1 to 1 part by weight, based on the weight of the ethylene-vinyl acetate copolymer. The amount is basically depended on the amount (ratio) of a vinyl acetate recurring unit of the ethylene-vinyl acetate copolymer. Generally the use of the crosslinking auxiliary agent within the above-mentioned range advantageously enables enhancement of transparency and repression of occurrence of acetic acid.

A vinyl acetate recurring unit of the ethylene-vinyl acetate copolymer is preferably contained in the amount of 25 to 29% by weight, especially 25 to 27% by weight, based on the weight of the ethylene-vinyl acetate copolymer. Thereby occurrence of acetic acid can be repressed and high transparency can be acquired. Further the resin film preferably has haze of not more than 3, especially not more than 1.

The crosslinking auxiliary agent preferably is triallyl isocyanurate.

The crosslinker preferably is 2,5-dimethyl-2,5-bis(t-butylperoxy)hexane, 1,1-bis(t-butylperoxy)-3,3,5-trimethylcyclohexane.

The resin film contains a benzotriazole compound, in order to prevent occurrence of corrosion such as rust on a metal part when the resin film is used as a sealing film of a solar cell or a laminated glass having the metal part therein.

### Effect of the Invention

The resin film of the invention has an extremely small amount of acetic acid contained therein and the property that the amount of acetic acid generated with time is also small, and therefore the contact of the resin film with metal scarcely brings about corrosion on the metal. Further the resin film of the invention has low haze and high transparency, and thus can be used in the use applications requiring properties not to bring about corrosion on metal and to maintain high transparency.

In more detail, when the resin film of the invention is used as a sealing film for a silicon photovoltaic element of a solar cell, the resin film represses occurrence of acetic acid to prevent occurrence of rust on conducting wire or electrode within the cell owing to permeation of moisture or water under high temperature. Further, when a laminated glass for reflecting heat rays, in which a deposited metal film is inserted between a glass plate and an EVA film (i.e., the resin film), is also improved in repression of occurrence of rust on the metal film in the same manner as above. Thus the resin film can be advantageously used in the above uses. Furthermore, the resin film can be also advantageously used in any use applications in which the resin film is in contact with metal.

### Brief Description of the Drawings

Fig. 1 is a section view showing a basic embodiment of a solar cell having the resin film of the invention therein.
Fig. 2 is a section view showing a basic embodiment of a laminated glass having the resin film of the invention therein.

### Description of the reference numbers

11: glass plate as transparent front surface (light receiving face) protection member
12: rear surface protection member (backside covering material)
13A, 13B: sealing film
14: silicon photovoltaic element
21, 23: glass plate
22: transparent adhesive layer
24A, 24B: deposited metal layer

### Detailed Description of the Invention

The resin film of the invention contains ethylene-vinyl acetate copolymer as a major ingredient and is sufficiently repressed in occurrence of acid.

Occurrence of acetic acid from the resin film of the invention is sufficiently repressed. Therefore, in case the resin film is used as a sealing film for a silicon photovoltaic element of a solar cell, the resin film enables to prevent occurrence of rust on conducting wire or electrode within the cell owing to permeation of moisture or water under high temperature. Further, a laminated glass for reflecting heat rays, in which a metal deposited film is inserted between a glass plate and an EVA film (i.e., the resin film), is also improved in repression of occurrence of rust on the metal film in the same manner as above. Furthermore, the resin film of the invention can be also advantageously used in any use applications in which the resin film is in contact with metal.

The resin film of the invention basically consists of ethylene-vinyl acetate copolymer, and further contains preferably a crosslinker, a crosslinking auxiliary agent, and additives such as a silane-coupling agent. These ingredients are appropriately combined with each other by suitably changing amounts and kinds of the ingredients, whereby an extracted acetic acid amount of the resin film can be controlled in the amount of not more than 200 ppm. The extracted acetic acid amount is an acetic acid amount obtained by allowing the resin film to stand for 100 hours under the conditions of temperature of 85°C and relative humidity of 85% (i.e., carrying out an accelerated durability test) and thereafter heating water containing the resin film under boiling and reflux to extract acetic acid from the resin film.

Ethylene-vinyl acetate copolymer (EVA) is typically used as organic resin of the resin film of the invention. If necessary, polyvinyl acetal resin (e.g., polyvinyl formal, polyvinyl butyral (PVB), modified PVB) and/or polyvinyl chloride can be used. The use of only EVA is preferred.

In EVA used in the resin film, the content of vinyl acetate recurring unit preferably is in the range of 20 to 40% by weight, more preferably 25 to 29% by weight, especially 25 to 27% by weight. When the content is less than 20% by weight, the resin cured at high temperature does not show satisfactory transparency. On the other hand, when the content is more than 40 % by weight, the resin is apt to generate acetic acid and not to satisfy impact resistance and penetration resistance required in the glass for prevention of crimes.

The EVA can contain various additives such as plasticizer, organic peroxide (crosslinker), and an adhesion promoter.

As the plasticizer, polybasic acid esters and polyhydric alcohol esters are generally employed although any plasticizers can be used without restriction. Examples of the esters include dioctyl phthalate, dihexyladipate, triethylene glycol-di-2-ethylbutylate, butyl sebacate, tetraethylene glycol heptanoate and triethylene glycol dipelargonate. The plasticizer can be used singly, or in combination of two or more kinds. The content of the plasticizer is generally in an amount of not more than 5 parts by weight based on 100 parts by weight of EVA.

The EVA generally contains organic peroxide or photosensitizer as a crosslinker in order to repress occurrence of acetic acid and to adjust adhesion to a glass plate or an organic polymer film. A resin film containing organic peroxide is improved in heat-curing property and hence the cured film shows enhanced film strength.

Any organic peroxides that can be decomposed at a temperature of not less than 100°C to generate radical(s) can be employed. The organic peroxide is selected in the consideration of film-forming temperature, condition for preparing the composition, curing (bonding) temperature, heat resistance of body to be bonded, storage stability. Especially, preferred are those having a decomposition temperature of not less than 70°C in a half-life of 10 hours.

Examples of the organic peroxide include 2,5-dimethylhexane-2,5-dihydroperoxide, 2,5-dimethyl-2,5-bis(t-butylperoxy)hexane, 2,5-dimethyl-2,5-di(t-butylperoxy)hexane-3-di-t-butylperoxide, t-butylcumyl peroxide, dicumyl peroxide, α,α'-bis(t-butylperoxyisopropyl)benzene, n-butyl-4,4-bis(t-butylperoxy)valerate, 2,2-bis(t-butylperoxy)butane, 1,1-bis(t-butylperoxy)cyclohexane, 1,1-bis(t-butylperoxy)-3,3,5-trimethylcyclohexane, t-butylperoxybenzoate, benzoyl peroxide, t-butylperoxyacetate, methyl ethyl ketone peroxide, 2,5-dimethyl-2,5-bis(t-butylperoxy)-3,3,5-trimethylcyclohexane, 2,5-dimethylhexyl-2,5-bisperoxybenzoate, t-butyl hydroperoxide, p-menthane hydroperoxide, p-chlorobenzoyl peroxide, hydroxyheptyl peroxide, chlorohexanone peroxide, octanoyl peroxide, decanoyl peroxide, lauroyl peroxide, cumyl peroxyoctoate, succinic acid peroxide, acetyl peroxide, t-butylperoxy(2-ethylhexanoate), m-toluoyl peroxide, t-butylperoxyisobutylate and 2,4-dichlorobenzoyl peroxide. The organic peroxide can be used singly, or in combination of two or more kinds. The content of the organic peroxide is generally in an amount of 0.1 to 5 parts by weight, preferably 0.1 to 2 parts by weight, 0.1 to 1 parts by weight, based on 100 parts by weight of EVA.

In case EVA is cured by light, a photosensitizer (photopolymerization initiator) is used instead of the organic peroxide, and it is generally used in an amount of 0.1 to 5 parts by weight, preferably 0.1 to 2 parts by weight, 0.1 to 1 parts by weight based on 100 parts by weight of EVA.

Examples of the photopolymerization initiator include benzoin, benzophenone, benzoin methyl ether, benzoin ethyl ether, benzoin isopropyl ether, benzoin isobutyl ether, dibenzyl, 5-nitroacenaphtene, hexachlorocyclopentadiene, p-nitrodiphenyl, p-nitroaniline, 2,4,6-trinitroaniline, 1,2-benzanthraquinone, 3-methyl-1,3-diaza-1,9-benzanthrone. The photopolymerization initiators can be used singly, or in combination of two or more kinds.

The EVA film of the invention preferably contains acryloxy group-containing compounds, methacryloxy group-containing compounds, epoxy group-containing compounds and/or polyfunctional compounds (crosslinking auxiliary agents) for improvement or adjustment of various properties of the film (e.g., mechanical strength, adhesive property (adhesion), optical characteristics such as transparency, heat resistance, light-resistance, cross-linking rate), as well as for repression of occurrence of acetic acid, particularly for improvement mechanical strength.

In case the above-mentioned compounds are added to EVA in a suitable amount, the EVA film is advantageously improved in transparency as well as repression of occurrence of acetic acid. Particularly, the addition of a suitable amount of crosslinking auxiliary agent brings about the EVA film having enhanced transparency and showing repression of occurrence of acetic acid.

Examples of the acryloxy and methacryloxy group containing compounds include generally derivatives of acrylic acid or methacrylic acid, such as esters and amides of acrylic acid or methacrylic acid. Examples of the ester residue include linear alkyl groups (e.g., methyl, ethyl, dodecyl, stearyl and lauryl), a cyclohexyl group, a tetrahydrofurfuryl group, an aminoethyl group, a 2-hydroxyethyl group, a 3-hydroxypropyl group, 3-chloro-2-hydroxypropyl group. Further, the esters include esters of acrylic acid or methacrylic acid with polyhydric alcohol such as ethylene glycol, triethylene glycol, polypropylene glycol, polyethylene glycol, trimethylol propane or pentaerythritol.

Example of the amide includes diacetone acrylamide.

Examples of polyfunctional compounds (crosslinking auxiliary agents) include esters of plural acrylic acids or methacrylic acids with polyhydric alcohol such as glycerol, trimethylol propane or pentaerythritol; and further triallyl cyanurate and triallyl isocyanurate. Preferred is triallyl isocyanurate.

Examples of the epoxy group containing compounds include triglycidyl tris(2-hydroxyethyl)isocyanurate, neopentylglycol diglycidyl ether, 1,6-hexanediol diglycidyl ether, allyl glycidyl ether, 2-ethylhexyl glycidyl ether, phenyl glycidyl ether, phenol(ethyleneoxy)₅glycidyl ether, p-tert-butylphenyl glycidyl ether, diglycidyl adipate, diglycidyl phthalate, glycidyl methacrylate and butyl glycidyl ether.

The acryloxy group-containing compounds, methacryloxy group-containing compounds and/or epoxy group-containing compounds, or the crosslinking auxiliary agent is generally used in an amount of 0.1 to 5 parts by weight, preferably 0.1 to 2 parts by weight, 0.1 to 1 parts by weight, based on 100 parts by weight of EVA.

In the invention, a silane coupling agent can be used as an adhesion promoter for enhancing the adhesive strength to the resin film and the glass plate or plastic film comprising polymer film.

Examples of the silane coupling agent include γ-chloropropylmethoxysilane, vinyltriethoxysilane, vinyl-tris(β-methoxyethoxy)silane, γ-methacryloxypropylmethoxysilane, vinyltriacetoxysilane, γ-glycidoxypropyltrimethoxysilane, γ-glycidoxypropyltriethoxysilane, β-(3,4-epoxycyclohexyl)ethyltrimethoxysilane, vinyltrichlorosilane, γ-mercaptopropylmethoxysilane, γ-aminopropyltriethoxysilane, N-β-(aminoethyl)-γ-aminopropyltrimethoxysilane. The silane coupling agents can be used singly, or in combination of two or more kinds. The content of the silane coupling agent is preferably in an amount of not more than 5 parts by weight, especially 0.1 to 1 part by weight, based on 100 parts by weight of EVA.

The resin film of the invention contains a benzotriazole compound in order to reduce extracted acetic acid amount to repress occurrence of corrosion such as rust. The benzotriazole compound is 1H-benzotriazole or a 1H-benzotriazole salt (e.g., potassium salt, sodium salt). The content of the benzotriazole compound is preferably in an amount of 0.01 to 5 part by weight based on 100 parts by weight of EVA. The addition of excess of the benzotriazole compound reduces curing rate.

PVB, which can be used as an organic resin other than EVA, has preferably 70 to 95 weight % of vinyl acetal unit and 1 to 15 weight % of vinyl acetal unit, and average polymerization degree of 200 to 3,000 (especially 300 to 2,500). The PVB is generally used as a resin composition containing plasticizer.

Examples of the plasticizer of the PVB composition include organic plasticizers such as monobasic acid ester and polybasic acid ester; and plasticizers derived from phosphoric acid.

As described previously, the resin film of the invention basically consists of ethylene-vinyl acetate copolymer, and further restricted so as to contain an extremely reduced concentration (200ppm or less, preferably 100ppm or less, especially 60ppm or less) of extracted acetic acid; the extracted acetic acid amount (concentration) being an acetic acid amount obtained by allowing the resin film to stand for 100 hours under the conditions of temperature of 85°C and relative humidity of 85% (i.e., carrying out an accelerated durability test) and thereafter extracting acetic acid from the resin film. The resin film having the extremely reduced extracted acetic acid concentration can be obtained, for example, by optimizing the amount of vinyl acetate recurring unit, the kinds and amount of the crosslinker and the kinds and amount of the crosslinking auxiliary agent. For instance, in case EVA having 26% by weight of vinyl acetate recurring unit is used, a resin film having extremely reduced extracted acetic acid concentration can be obtained by appropriately selecting the kinds of the crosslinker, the amount of the crosslinker in the range of 0.2 to 2 % by weight, especially 0.2 to 1 % by weight, the kinds of the crosslinking auxiliary agent, and the amount of the crosslinking auxiliary agent in the range of 0.5 to 2 % by weight, especially 0.5 to 1 % by weight. Particularly, the use of the crosslinker and crosslinking auxiliary agent in a small amount advantageously brings about a resin film having extremely reduced extracted acetic acid concentration. This is because the resultant film has a suitable crosslinking structure with maintain high transparency, whereby it is considered that ester bonding portions of the film is protected from water attack.

In the invention, after an acceleration test of durability, that the resin film is allowed to stand for 100 hours under the conditions of temperature of 85°C and relative humidity of 85%, is performed, the amount of acetic acid extracted from the resin film by boil-heating reflux using water is 200ppm or less. The boil-heating reflux is carried out as follows: a resin film (EVA film; thickness of 600µm) after an acceleration test of durability is cut to a size of approx. 3×3mm as a sample, the sample and distillated water having the same weight as the sample are placed in a flask equipped with a condenser tube, and the flask is heated for 24 hours such that the water is refluxed under boiling, and then the treated water is subjected to ion-chromatography to determine an amount of extracted acetic acid from the resin film.

The resin film of the invention can be prepared, for example, by subjecting a composition including EVA, etc., to a conventional molding process such as extrusion molding or calendaring to form a sheet-shaped material. Otherwise, the resin film can be also obtained by dissolving the composition including EVA, etc., in a solvent to form a solution and coating and drying the solution on an appropriate support by means of an appropriate coater to form a coated layer.

Thickness of the resin film of the invention preferably is in the range of 0.1 to 1mm, especially 0.1 to 0.5mm.

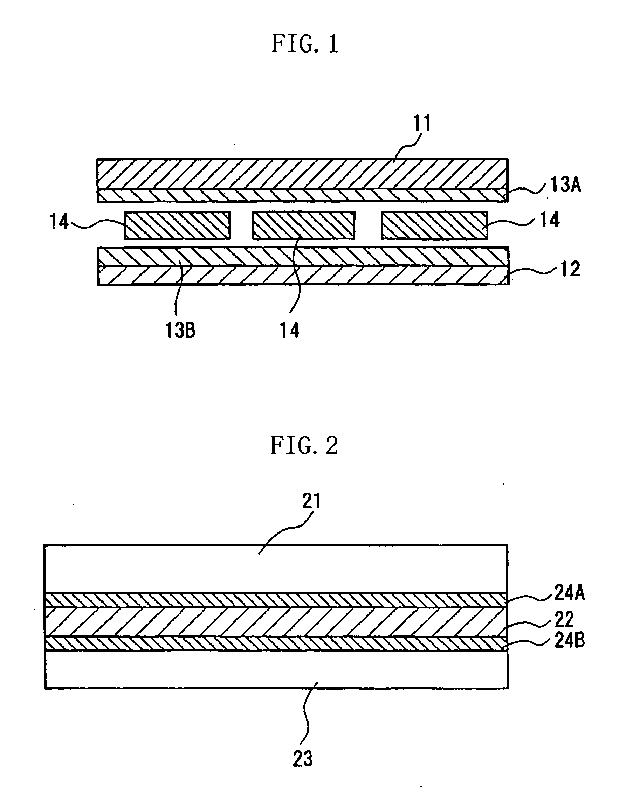

An example of a solar cell provided with the resin film of the invention is shown in Fig. 1, and an example of laminated glass provided with the resin film of the invention is shown in Fig. 2, whereby the invention is further explained.

In Fig. 1, silicon photovoltaic elements 14 are sealed by ethylene-vinyl acetate copolymer (EVA) sealing films (resin films of the invention) 13A, 13B between a glass plate 11 as a transparent front surface (light receiving face) protection member and a rear surface protection member (backside covering material) 12. When acetic acid is leached out of the resin film, rust is apt to generate on an electrode of the photovoltaic element. However, the use of the resin film of the invention enables repression of occurrence of the rust.

The solar cell can be easily prepared by heat-pressing the above-mentioned laminating body using vacuum laminator according to conventional methods, preferably under the conditions of temperature of 120 to 150°C, degassing time period of 2 to 15 minutes, pressure of press of 0.5 to 1 atm, and pressing time period of 8 to 45 minutes.

In Fig. 2, the transparent adhesive layer (a resin film of the invention) 22 is inserted between a glass plate 21 and a glass plate 23. Deposited metal films 24A, 24B each are formed on the glass plate 21 and the glass plate 23, and the transparent adhesive layer 22 is directly in contact with the deposited metal films 24A, 24B. When acetic acid is leached out of the resin film of the transparent adhesive layer, rust is apt to generate on an electrode of the photovoltaic element. However, the use of the resin film of the invention enables repression of occurrence of the rust.

The above-mentioned laminated glass can be prepared, for example, by inserting the resin film between two floating glasses provided with the deposited metal film such that the resin film is in contact with a surface of the deposited metal film, degassing the laminate in vacuum and pre-bonding it (glass laminate) under pressure, and then heat-bonding it (glass laminate) in an oven.

The invention is illustrated in detail using the following Examples.

### EXAMPLE

### [Examples 1 to 6 & Comparison Examples 1 to 5]

### (1) Preparation of film

The gradients of each formulation shown in Tables 1 and 2 were kneaded at 80°C for 15 minutes by means of a roll mil to prepare a resin composition, and the resin composition was inserted between two PET films to be press forming at 100°C for five minutes, and allowed to stand to cool. Thereafter the PET film was peeled form both sides of the resultant laminated body to obtain a resin film having thickness of 0.6mm.

### (2) Preparation of laminated glass

The resultant resin film was inserted between two floating glass plates (thickness: 3mm) whose surface was deposited by silver such that the silver films are in contact with the resin film, and the glass plates having the film was put into a PET case to be degassed in vacuum and then preliminary bonded at approx. 80°C under pressure. The bonded glasses was introduced into an oven and heated at 150°C for time period shown in Table 1, the time period being measured from a point that a surface temperature of the laminate reaches 150°C at atmosphere pressure, to prepare a laminated glass. The time period was 30 minutes in Examples 5, 6 and Comparison Examples 4,5.

### <Evaluation on resin film >

The resultant resin films are evaluated as follows:

### (1) Loss in weight after heating

The resultant film having thickness of 0.6mm (approx. 1g) is heated at 160°C for 30 minutes to measure loss in weight of the film.

### <Evaluation on laminated glass >

The resultant laminated glasses are evaluated as follows:

### (2) Haze

Three test pieces having size of 50×50mm are cut out of the central area of the laminated glass and haze values of the three test pieces are measured by using Color Computer SM-3 (available from Suga Test Instruments Co., Ltd.). The mean value of the three test pieces is reported as haze in Table 1.

### (3) Accelerated durability test

The laminated glass is allowed to stand for 100 hours under environment of temperature of 85°C and relative humidity of 85% (i.e., carrying out an accelerated durability test) and thereafter it is observed whether the deposited silver film is corroded or not, which evaluated as follow:
○: discoloration is observed,
Δ: slight discoloration is observed,
×: discoloration is observed.

### (4) Determination of amount of acetic acid

The laminated glass subjected to the accelerated durability test (3) is cut to a size of approx. 3x3mm as a sample, the sample and distillated water having the same weight as the sample are placed in a flask equipped with a condenser tube, and the flask is heated for 24 hours such that the water is refluxed under boiling. The treated water phase is taken out and subjected to an ion-chromatography process to determine an amount of extracted acetic acid. The resultant acetic acid concentration is considered as acetic acid concentration of the resin film.

**Table 1**

| | Ex. 1 | Ex. 2 | Ex. 3 | Ex. 4 | Co. 1 | Co. 2 | Co. 3 |
|---|---|---|---|---|---|---|---|
| Formulation | | | | | | | |
| EVA 1 | 100 | 100 | 100 | | | | 100 |
| EVA 2 | | | | 100 | 100 | 100 | |
| Crosslinker | 0.5 | 1 | 2 | 2 | 3 | 2 | 0.5 |
| Crosslinking auxiliary | 1 | 1 | 2 | 2 | 2 | 2 | 1 |
| Additive | 0.5 | 0.5 | 0.5 | 0.5 | 0.5 | 0.5 | 0.5 |
| Acetic acid | - | - | - | - | - | - | 0.02 |
| Heating period | 30 | 30 | 30 | 30 | 30 | 60 | 30 |

| Evaluation | | | | | | | |
|---|---|---|---|---|---|---|---|
| Acetic acid conc. W | 20 | 40 | 100 | 160 | 240 | 300 | 220 |
| Haze | ≤1% | ≤1% | ≤1% | ≤1% | ≤1% | ≤3% | ≤3% |
| Durability | ○ | ○ | ○ | ○ | × | × | × |
| Loss in weight | 1.8 | 1.7 | 1.6 | 1.7 | 1.8 | 1.8 | 2.0 |

| | | | | | | | |
|---|---|---|---|---|---|---|---|
| Remarks: EVA 1: Ethylene-vinyl acetate copolymer (content of vinyl acetate recurring unit: 26 wt. %) EVA 2: Ethylene-vinyl acetate copolymer (content of vinyl acetate: recurring unit: 28 wt. %) Crosslinker: 2,5-dimethyl-2,5-bis (t-butylperoxy)hexane Crosslinking auxiliary (agent): triallyl isocyanurate Additive: γ-methacryloxypropyl trimethoxy silane Acetic acid conc. W: extracted amount by distilled water | | | | | | | |

**Table 2**

| | Ex. 5 | Ex. 6 | Co. 4 | Co. 5 |
|---|---|---|---|---|
| Formulation | | | | |
| EVA 2 | 100 | 100 | 100 | 100 |
| Crosslinker | 2 | 2 | 2 | 2 |
| Crosslinking auxiliary | 2 | 2 | 2 | 2 |
| Additive | 0.5 | 0.5 | 0.5 | 0.5 |
| 1H-Triazole | 0.01 | 0.1 | - | 0.001 |

| Evaluation | | | | |
|---|---|---|---|---|
| Acetic acid conc. W | 110 | 100 | 290 | 240 |
| Durability | ○ | ○ | × | Δ |
| Loss in weight | 1.7 | 1.7 | 1.8 | 1.7 |

| | | | | |
|---|---|---|---|---|
| Remarks: EVA 2: Ethylene-vinyl acetate copolymer (content of vinyl acetate: recurring unit: 28 wt. %) Crosslinker: 1,1-bis (t-butylperoxy)trimethylcyclohexane Crosslinking auxiliary (agent): triallyl isocyanurate Additive: γ-methacryloxypropyl trimethoxy silane Acetic acid conc. W: extracted amount by distilled water | | | | |

As apparent from the results of Tables 1 and 2, the laminates glasses of Examples 1-6 according to the invention are excellent in both characteristics of haze and durability. Further, the results reveals that the acetic acid concentration correlates with the durability.

### Industrial Applicability

The resin film of the invention has an extremely small amount of acetic acid contained therein and the property that the amount of acetic acid generated with time is also small, and therefore the contact of the resin film with metal scarcely brings about corrosion on the metal. Further the resin film of the invention has low haze and high transparency, and thus can be used in the use applications requiring properties not to bring about corrosion on metal and to maintain high transparency. The use applications include a sealing film for silicon photovoltaic elements of a solar cell, and an adhesive layer of a laminated glass for reflecting heat rays.

## Claims

1. A resin film comprising ethylene-vinyl acetate copolymer and 1H-benzotriazole or a salt thereof,
which has an extracted acetic acid amount of not more than 200 ppm, the extracted acetic acid amount being an acetic acid amount obtained by allowing the resin film to stand for 100 hours under the conditions of temperature of 85°C and relative humidity of 85% and thereafter heating water containing the resin film under boiling and reflux to extract acetic acid from the resin film.

2. A resin film as defined in claim 1, wherein the extracted acetic acid amount is not more than 100 ppm.

3. A resin film as defined in claim 1 or 2, wherein the ethylene-vinyl acetate copolymer has been further crosslinked by a crosslinker.

4. A resin film as defined in claim 3, wherein the ethylene-vinyl acetate copolymer has been further crosslinked by a crosslinking auxiliary agent.

5. A resin film as defined in claim 4, wherein the crosslinking auxiliary agent Is triallyl (iso)cyanurate.

6. A resin film as defined in any of claims 3 to 5, wherein the crosslinker is contained in the amount of 0.1 to 1 part by weight based on the amount of the ethylene-vinyl acetate copolymer.

7. A resin film as defined in claim 6, wherein loss in weight after heating the resin film at 160°C for 30 minutes is not more than 2.0 % by weight based on the resin film before the heating.

8. A resin film as defined in any of claims 1 to 7, which further contains a silane-coupling agent.

9. A resin film as defined in any of claims 1 to 8, wherein a vinyl acetate recurring unit of the ethylene-vinyl acetate copolymer is contained in the amount of 25 to 27% by weight based on the weight of the ethylene-vinyl acetate copolymer.

10. A resin film as defined In any of claims 1 to 9, which has haze of not more than 3.

## Patentansprüche

1. Harzfolie umfassend Ethylen-Vinylacetat-Copolymer und 1H-Benzotriazol oder ein Salz davon,
die eine Menge extrahierter Essigsäure von nicht mehr als 200 ppm aufweist, wobei die Menge extrahierter Essigsäure eine Menge Essigsäure ist, die durch Stehenlassen der Harzfolie für 100 Stunden unter Bedingungen einer Temperatur von 85 °C und einer relativen Feuchte von 85 % und darauf Erhitzen von Wasser, das die Harzfolie enthält, unter Sieden und am Rückfluss, um die Essigsäure aus der Harzfolie zu extrahieren, erhalten wird.

2. Harzfolie wie in Anspruch 1 definiert, wobei die Menge extrahierter Essigsäure nicht mehr als 100 ppm beträgt.

3. Harzfolie wie in Anspruch 1 order 2 definiert, wobei das Ethylen-Vinylacetat-Copolymer noch weiter durch ein Vernetzungsmittel vernetzt worden ist.

4. Harzfolie wie in Anspruch 3 definiert, wobei das Ethylen-Vinylacetat-Copolymer noch weiter durch ein Vernetzungshilfsmittel vernetzt worden ist.

5. Harzfolie wie in Anspruch 4 definiert, wobei das Vernetzungshilfsmittel Triallyl(iso)cyanurat ist.

6. Harzfolie wie in einem der Ansprüche 3 bis 5 definiert, wobei das Vernetzungsmittel in der Menge von 0,1 bis 1 Gewichtsteil, auf die Menge des Ethylen-Vinylacetat-Copolymers bezogen, enthalten ist.

7. Harzfolie wie in Anspruch 6 definiert, wobei der Gewichtsverlust nach Erhitzen der Harzfolie bei 160 °C für 30 Minuten nicht mehr als 2,0 Gew.%, auf die Harzfolie vor dem Erhitzen bezogen, beträgt.

8. Harzfolie wie in einem der Ansprüche 1 bis 7 definiert, die des Weiteren einen Silanhaftvermittler enthält.

9. Harzfolie wie in einem der Ansprüche 1 bis 8 definiert, wobei eine Vinylacetatwiederholungseinheit des Ethylen-Vinylacetat-Copolymers in der Menge von 25 bis 27 Gew.-%, auf das Gewicht des Ethylen-Vinylacetat-Copolymers bezogen, enthalten ist.

10. Harzfolie wie in einem der Ansprüche 1 bis 9 definiert, die eine Trübung von nicht mehr als 3 aufweist.

## Revendications

1. Film de résine comprenant un copolymère d'éthylène-acétate de vinyle et du 1H-benzotriazole ou un sel de celui-ci,
qui possède une quantité d'acide acétique extrait de pas plus de 200 ppm, la quantité d'acide acétique extrait étant une quantité d'acide acétique obtenue en laissant le film de résine reposer pendant 100 heures dans les conditions de température de 85°C et d'humidité relative de 85% et par la suite en chauffant l'eau que le film de résine contient sous ébullition et reflux pour extraire l'acide acétique du film de résine.

2. Film de résine selon la revendication 1, dans lequel la quantité d'acide acétique extrait est de pas plus de 100 ppm.

3. Film de résine selon la revendication 1 ou 2, dans lequel le copolymère d'éthylène-acétate de vinyle a été réticulé davantage par un agent de réticulation.

4. Film de résine selon la revendication 3, dans lequel le copolymère d'éthylène-acétate de vinyle a été réticulé davantage par un agent auxiliaire de réticulation.

5. Film de résine selon la revendication 4, dans lequel l'agent auxiliaire de réticulation est l'(iso)cyanurate de triallyle.

6. Film de résine selon l'une quelconque des revendications 3 à 5, dans lequel l'agent de réticulation est contenu dans la quantité de 0,1 à 1 partie en poids sur la base de la quantité du copolymère d'éthylène-acétate de vinyle.

7. Film de résine selon la revendication 6, dans lequel la perte en poids après le chauffage du film de résine à 160°C pendant 30 minutes est de pas plus de 2,0% en poids sur la base du film de résine avant le chauffage.

8. Film de résine selon l'une quelconque des revendications 1 à 7, qui contient en outre un agent de couplage de silane.

9. Film de résine selon l'une quelconque des revendications 1 à 8, dans lequel une unité récurrente d'acétate de vinyle du copolymère d'éthylène-acétate de vinyle est contenue dans la quantité de 25 à 27% en poids sur la base du poids du copolymère d'éthylène-acétate de vinyle.

10. Film de résine selon l'une quelconque des revendications 1 à 9, qui présente un trouble de pas plus de 3.
